# EUROPÄISCHE PATENTSCHRIFT

(11) **EP 0 513 662 B1**
(45) Veröffentlichungstag und Bekanntmachung des Hinweises auf die Patenterteilung: **28.02.1996**
(21) Anmeldenummer: 92107708.7
(22) Anmeldetag: 07.05.1992
(51) Int. Cl.: C23C 14/08, C23C 16/40, C23C 30/00

(54) **Verfahren zum Beschichten des Werkstückes und mit einer Hartschicht versehener Grundkörper**
Work piece coated with a hard layer and process for coating with the layer
Pièce revêtue d'une couche dure et procédé de revêtement

(30) Priorität: 16.05.1991 CH 1470/91
(43) Veröffentlichungstag der Anmeldung: 19.11.1992
(73) Patentinhaber: BALZERS AKTIENGESELLSCHAFT, FL-9496 Balzers (LI)
(72) Erfinder: Schulz, Hans, FL-9496 Balzers (LI); Bergmann, Erich, CH-8887 Mels (CH)
(74) Vertreter: Troesch Scheidegger Werner AG

(56) Entgegenhaltungen:
- FR-A- 2 422 728
- THIN SOLID FILMS. Bd. 138, Nr. 1, April 1986, LAUSANNE CH Seiten 49 - 64; LUX ET AL.: 'PREPARATION OF ALUMINA COATINGS BY CHEMICAL VAPOUR DEPOSITION'
- THIN SOLID FILMS. Bd. 153, Nr. 1, 26. Oktober 1987, LAUSANNE CH Seiten 123 - 133; ROTH ET AL.: 'STRUCTURE, INTERNAL STRESSES, ADHESION AND WEAR RESISTANCE OF SPUTTERED ALUMINA COATINGS, seite 124, Absart 2
- AMERICAN CERAMIC SOCIETY BULLETIN Bd. 56, Nr. 5, Mai 1977, COLUMBUS, US Seiten 504 - 512; THORNTON ET AL.: 'STRUCTURE AND HEAT TREATMENT CHARACTERISTICS OF SPUTTER-DEPOSITED ALUMINA'

## Beschreibung

Die vorliegende Erfindung betrifft ein Verfahren nach dem Oberbegriff von Anspruch 1, einen Grundkörper nach demjenigen von Anspruch 10 sowie Verwendungen des Verfahrens nach Anspruch 17 und des Grundkörpers nach Anspruch 18.

Aluminiumoxid zeichnet sich vor allem durch eine sehr hohe thermodynamische Stabilität und eine vergleichsweise hohe Härte aus. Als thermodynamische Stabilität wird seine Resistenz, auch bei hohen Temperaturen, in aggressiver Umgebung verstanden. Neben der Verwendung an Verschleissteilen in aggressiven Medien wird Aluminiumoxid als Schichtwerkstoff, insbesondere für Werkzeuge, zur spanenden Bearbeitung eingesetzt. Schichten aus Aluminiumoxid finden weiterhin für optische und elektronische Zwecke Anwendung. Bekannt ist die Abscheidung von Aluminiumoxidschichten mittels chemischer oder physikalischer Gasphasenabscheidung, CVD oder PVD.

Bei der chemischen Abscheidung wird Aluminiumchlorid mit Wasserdampf zur Reaktion gebracht. Bei Reaktionstemperaturen von 1000°C wachsen Schichten mit einer Rate von maximal 0.3µm/h auf, wie in dem Artikel "Aluminiumoxid-CVD mit einem AlCl₃/O₂ Reaktionsgemisch" von H. Altena et al., R & HM, March 1987, ausgeführt. Das dort beschriebene Verfahren wird zur Beschichtung von Hartmetallen eingesetzt. Die Schichten wachsen kristallin auf, wobei allgemein die α- oder κ-Modifikation von Aluminiumoxid entsteht, s. auch S. Vuorinen et al., "Characterization of α-Al₂O₃, κ-Al₂O₃, and α-κ multioxide coatings on cemented carbides", Thin Solid Films, 193/194 (1990) 536-546.

Da die α-Modifikation die höhere thermische Stabilität aufweist, zeigt sie auch ein besseres Verschleissverhalten. Da weiter dabei die Keimbildung auf dem Substrat recht inhomogen verläuft, muss zum Erreichen einer zusammenhängenden Schicht zuerst eine Zwischenschicht aufgebracht werden, wie dies aus M. Kornmann et al., "Nucleation of Alumina Layers on TiC and Cemented Carbides by Chemical Vapor Deposition", J. Cryst. Growth, 28 (1975), 259-262, hervorgeht. Bei technischen Prozessen wird im allgemeinen eine TiC-Zwischenschicht verwendet.

Verwendet man anstatt eines Aluminiumchlorids, als Al-Spender, eine metallorganische Verbindung, wie Aluminiumtriisopropylat oder Aluminiumtrimethyl, so lässt sich die Abscheidetemperatur bis auf ca. 420°C senken, wie sich aus J.E. Carnes et al., "Self-Healing Breakdown Measurements of Pyrolytic Aluminum Oxide Films on Silicon", Journal of Applied Physics, 42 (11), 4350-4356 (1971), ergibt. Dieses Verfahren kommt z.B. bei der Herstellung von elektronischen Schaltkreisen zur Anwendung. Es entsteht eine amorphe, d.h. nicht kristalline Aluminiumoxidschicht.

Bei der physikalischen Abscheidung von Aluminiumoxid lassen sich Aufdampf- und Aufstäubverfahren (sputter-Verfahren) einsetzen. Die so hergestellten Schichten finden sich bei optischen und elektronischen Anwendungen.

Bei abgestäubten Schichten ergibt sich bei Werkstücktemperatur unterhalb 500°C eine amorphe Struktur. Erst oberhalb einer Werkstücktemperatur von 1100°C scheidet sich die α-Modifikation von Aluminiumoxid ab, wie sich aus J.A. Thornton, "Structure and Heat Treatment Characteristics of Sputter-Deposited Alumina", Am. Ceram. Soc. Bull., 56 (5), 504-508, 512 (1977), ergibt.

In R.F. Bunshah et al., "Alumina Deposition by Activated Reactive Evaporation", Thin Solid Films, 40, 211-216 (1977), ist das reaktive, plasmaunterstützte Aufdampfen von Aluminiumoxid beschrieben. Auch hier werden erst ab einer Werkstücktemperatur > 1100°C kristalline Schichten in α-Modifikation gefunden. Die mechanischen Eigenschaften dieser Schichten sind jedoch schlecht. So wird die Schichthärte mit 500 bis 800HV angegeben. Auch werden die Schichten als porös und schlecht haftend beschrieben.

Aus der FR-A-2 422 728 ist es bekannt, auf einem Hartmetall-Grundkörper eine Cr-Schicht durch ein galvanisches Verfahren aufzubringen. Darnach wird der beschichtete Grundkörper auf 1000°C erhitzt. Bei dieser Temperatur wird dann der Cr-beschichtete Grundkörper einer Gasströmung mit einer Al-Verbindung ausgesetzt, wodurch sich eine Schicht aus α-(Al,Cr)₂O₃ bildet.

Die vorliegende Erfindung setzt sich zur Aufgabe:
- ein Verfahren letztgenannter Art als Vakuumbeschichtungsverfahren auszubilden und damit eine Hartschicht auf Aluminiumoxidbasis schaffen zu können, die einerseits ausserordentlich hart ist, mindestens gleich hart wie durch Hochtemperatur-CVD-hergestellte Aluminiumoxidschichten, die aber bei wesentlich tieferen Temperaturen hergestellt werden kann, und, aus Wirtschaftlichkeitsgründen, mit einer hohen Abscheidungsrate, worunter die pro Zeiteinheit abgeschiedene Schichtmaterialmenge am Werkstück verstanden sei, weiter
- einen beschichteten Grundkörper eingangs genannter Art zu schaffen mit verbesserten mechanischen Eigenschaften.

Diese Aufgabe wird durch das Verfahren nach Anspruch 1 bzw. den Grundkörper nach Anspruch 10 gelöst.

Erstaunlicherweise ergibt sich, durch die höchst einfache Massnahme, dem Schichtmaterial Aluminium Chrom beizugeben, bei Beschichtungstemperaturen unter 1000°C, nämlich unter 900°C, ja sogar unter 500°C, eine Hartschicht, die, wie sonst nur mit Hochtemperatur-CVD erreichbar, kristallin ist und, wo sonst nur amorphe Schichten erhalten werden, bei Temperaturen weit unterhalb 1000°C, bei 500°C und weniger, aufgebracht werden kann.

Bei bisher bekannten Vorgehensweisen müssen entweder hohe Werkstücktemperaturen in Kauf genommen werden, oder es entsteht nur eine amorphe Aluminiumoxidschicht, die hohen mechanischen Belastungen, wie sie bei Werkzeugen, insbesondere bei Werkzeugen für spanende Arbeiten, auftreten, nicht gewachsen ist.

Es ist nämlich bekannt, dass Schichten, insbesondere auf Werkzeugen, nur dann eine massgebliche verschleisshemmende Wirkung aufweisen können, wenn die

Schichthärte höher ist als abrasiv wirkende Bestandteile und Einschlüsse im Werkstoff, womit das Werkstück in reibendem Eingriff steht, also beispielsweise den zu bearbeitenden Werkstoff. Aus diesem Grunde konnten bislang nur die mit Hochtemperatur-CVD-Verfahren abgeschiedenen Aluminiumoxidschichten für einen wirksamen Verschleissschutz eingesetzt werden.

Weiter ist es ja bekannt, dass Schichtwerkstoffe einen gewissen Kristallisationsgrad aufweisen müssen, um bei mechanischen Spannungsspitzen der Belastung nicht durch Rissbildung zu versagen. Die bislang bekannten, mittels physikalischer Abscheidung (Verdampfen, Zerstäuben) aufgebrachten Aluminiumoxidschichten sind deshalb aufgrund ihrer geringen Härte und wegen der fehlenden Kristallinität für den Verschleissschutz von Werkstücken, insbesondere von Werkzeugen, dabei ganz besonders für Werkzeuge für die spanende Bearbeitung, nicht geeignet.

Insbesondere wurde somit erfindungsgemäss die Forderung nach einer Beschichtungstemperatur ≦ 500°C erfüllt, womit auch Werkzeuge aus Schnellarbeitsstahl mit einer solchen Schicht versehen werden können, ohne dass nach der Beschichtung ein Härten der Werkzeuge vorgenommen werden müsste. Auch für die Beschichtung von Hartmetallwerkzeugen ergibt sich die Forderung nach einer tiefen Beschichtungstemperatur, da hohe Werkstücktemperaturen deren Bruchfestigkeit verringern, was erfindungsgemäss gelöst ist.

Besonders bei Anwendungen an Werkzeugen für die spanende Bearbeitung mit Bearbeitungsunterbrüchen, also bei thermischer und mechanischer Wechselbelastung, kann eine zu geringe Bruchfestigkeit zum vorzeitigen Ausfall des Werkzeuges führen.

Es versteht sich von selbst, dass die Forderung nach einer hohen Beschichtungsrate sich aus wirtschaftlichen Gesichtspunkten ergibt. Zwar ist es aus J.S. Yoon et al., "Fabrication of Aluminum Oxide Films with high Deposition Rates using the Activated Reactive Evaporation Technique", Surface and Coatings Technology, 43/44 (1990), 213-222, bekannt, mittels eines Aufdampfverfahrens Aluminiumoxid mit einer Rate von 6µm/h bei statischer Beschichtung herzustellen, jedoch erhält man auch bei diesem Verfahren eine amorphe, nicht kristalline Schicht. Erst durch nachträgliche Glühung eines mit der Schicht versehenen Werkstückes bei 1200°C bildet sich die α-Modifikation des Aluminiumoxids.

Die Erfindung wird anschliessend anhand von Beispielen erläutert, wobei Bezug genommen wird auf die beispielsweise gezeigten Figuren, welche zeigen:
- Fig. 1: den Verlauf der Knoop-Härte dreier erfindungsgemässer Hartschichten in Abhängigkeit vom Chromanteil in at% in der als Beispiel verdampften Schmelze, wobei die drei Schichten bei unterschiedlichen Temperaturen hergestellt wurden. Zum Vergleich eingetragen: die Knoop-Härte von Saphir;
- Fig. 2: ein Röntgenspektrum einer erfindungsgemässen, bei 500°C aufgedampften Schicht;
- Fig. 3: eine mit Leisten versehene, mit einem erfindungsgemässen Werkzeug zu bearbeitende Welle als Normwerkstück;
- Fig. 4: schematisch eine Wendeschneidplatte mit ihren Abnützungen;
- Fig. 5: schematisch eine für das erfindungsgemässe Verfahren beispielsweise eingesetzte Anlage.

Die erfindungsgemässe Hartschicht besteht im wesentlichen aus (Al, Cr)₂O₃-Kristallen, die mittels eines chemischen oder eines physikalischen Abscheideverfahrens aufgebracht sind. Dabei bestehen verschiedene Möglichkeiten, die Schicht aufzubringen:

### 1. Ausgangszustand:

Aluminium und Chrom metallisch:

In diesem Falle kann getrennt Aluminium und Chrom durch je einen Elektronenstrahl verdampft werden, in eine Sauerstoffatmosphäre, oder es kann das Aluminium und das Chrom je getrennt mittels Lichtbogen verdampft werden, oder es kann Aluminium und Chrom, je getrennt, DC- oder AC-zerstäubt werden (sog. co-sputtern), ebenfalls in eine Sauerstoffatmosphäre.

Im weiteren kann hier das Aluminium metallisch mit dem metallischen Chrom gemeinsam, wie beispielsweise durch Vermischen von Aluminium- und Chrompulver, wiederum mittels Elektronenstrahl oder Lichtbogen verdampft oder zerstäubt werden. Dies wiederum in einer Sauerstoffatmosphäre.

### 2. Ausgangszustand:

Aluminiumoxid und metallisches Chrom:

In diesem Falle kann das Aluminiumoxid AC-zerstäubt werden, dabei das Chrom im Sinne einer Co-Zerstäubung, getrennt DC- oder AC-zerstäubt werden. Auch hier kann das Aluminiumoxid und, getrennt davon, das metallische Chrom mittels Elektronenstrahlen je verdampft werden. Bevorzugterweise erfolgt auch in diesem Falle eine Abscheidung in eine reaktive Sauerstoffatmosphäre.

Im weiteren können Al₂O₃ und metallisches Chrom gemeinsam elektronenstrahl- oder lichtbogenverdampft oder zerstäubt werden.

Auch ion-plating kann für die Ausgangszustände 1. und *2.* eingesetzt werden.

In allen Fällen wird der Beschichtungsprozess so gefahren, dass das zu beschichtende Werkstück einer Temperatur ≼ 900°c ausgesetzt ist, bevorzugterweise ≼ 500°C.

Vakuumbeschichtungsanlagen, wie AC- oder DC-sputter-Anlagen, Anlagen für die Elektronenstrahlverdampfung. die Lichtbogenverdampfung oder ion-plating, sind bekannt.

Im Moment wird das Verdampfen einer metallischen Aluminium/Chrommischung in reaktive Sauerstoffatmosphäre aus einem Tiegel mittels einer Niedervoltbogenentladung in den Tiegel bevorzugt.

Beim erwähnten, bevorzugten Verdampfen mittels Niedervoltbogenentladung auf einen Tiegel wurde es im weiteren als wesentlich erkannt, einen sog. Titan-Liner einzusetzen, d.h., zwischen der Wandung des Kupfertiegels und dem Beschichtungsgut, eine Titanzwischenlage vorzusehen. Dadurch wird einerseits eine optimale Wärmeisolation zwischen Beschichtungsgut und Kupfertiegel erreicht, somit kleinstmögliche Wärmeverluste, und es wird durch das Mitschmelzen von Titan die Reaktivität des Aluminiums mit Sauerstoff günstig beeinflusst. Dabei verdampfen aufgrund des hohen Unterschiedes der Dampfdrücke von Aluminium und Titan (fünf Grössenordnungen) nur sehr unbedeutende Mengen von Titan und finden sich in der aufgebrachten Hartschicht wieder. Die Verwendung eines Titan-liners lässt sich aber an der Schicht durch einen Titangehalt mit weniger als 1at% feststellen.

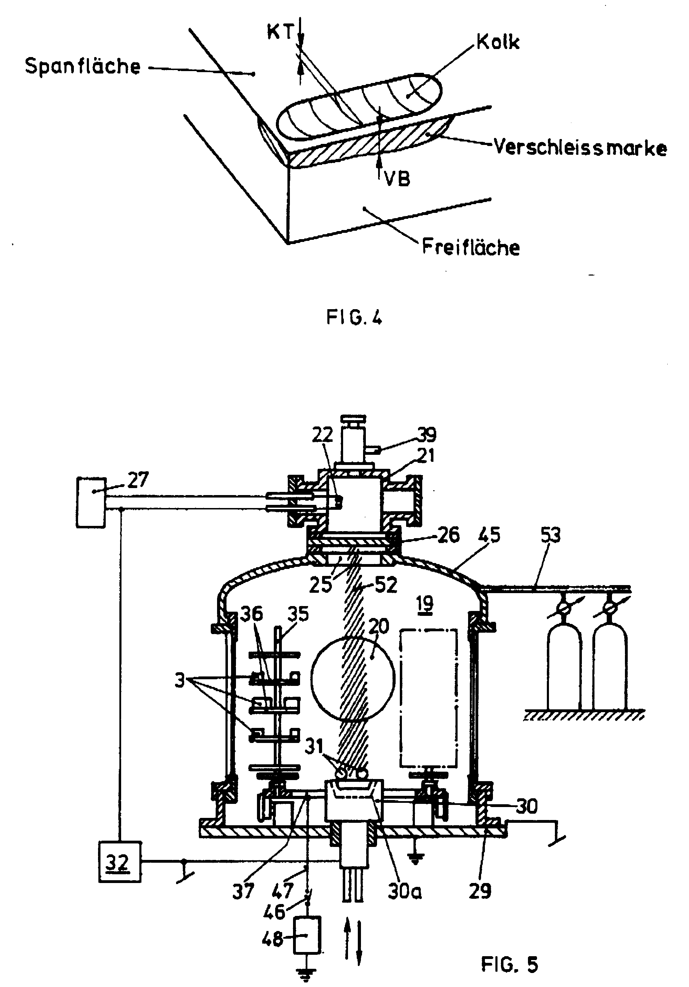

Es werden nachfolgend Herstellungsbeispiele der erfindungsgemässen Hartschicht dargestellt, hergestellt mit einem bevorzugten Herstellungsverfahren als Beispiel und, weiter als Beispiel, abgelegt an Werkzeugen für die spanende Bearbeitung, insbesondere an Wendeschneidplatten. Eine z.B. eingesetzte Anlage ist in Fig. 5 dargestellt und ist weiter unten kurz beschrieben.

### A) Beschichtung nur mit Aluminiumoxid (als Vergleichsverfahren)

Es Wurde Aluminium in einen Titan-liner in einem Kupfertiegel mit einer zwischen Tiegel bzw. Liner bzw. Aluminium unterhaltenen Niedervoltbogenentladung (Plasma) verdampft. Dabei wurden zuerst in den Titan-liner 50g Aluminiun in Tablettenform gelegt und der Titan-liner in den Kupfertiegel gestellt. Die vakuumbeschichtungskammer wurde auf einen Druck von 2 x 10⁻⁵ mbar evakuiert und Hartmetall-Werkstücke auf eine Temperatur zwischen 400°C und 600°C aufgeheizt, darnach durch Beschuss mit Argonionen geätzt.

Anschliessend, d.h. nach dem reinigenden Aetzprozess, wurde nun die Niedervoltbogenentladung bei einem Argondruck von 15 x 10⁻⁴ mbar auf den Tiegel bzw. den Liner bzw. das Aluminium gezündet.

Bei einem Bogenstrom von 80A wurde das Aluminium aufgeschmolzen und legierte teilweise mit dem Titan, ohne dass eine wesentliche Verdampfung von Aluminium einsetzte, Nach etwa 4min war dieser Vorgang abgeschlossen, und der bogenstrom wurde auf 120A erhöht, womit die Verdampfung von Aluminium begann. Wie erwähnt, wurden dabei aufgrund des hohen Unterschiedes der Dampfdrücke von Aluminium und Titan nur unbedeutende Mengen von Titan verdampft. Innerhalb der nächsten 4min wurde Aluminium ohne Zusatz von Reaktivgas verdampft, um eine metallische Zwischenschicht auf das Hartmetall-Werkstück aufzubringen (Hartmetall: Wolframkarbid + Kobalt).

Danach erfolgte der Einlass des Reaktivgases Sauerstoff, indem ein Zuführventil stetig geöffnet wurde, so dass Sauerstoff entsprechend einem stetigen, zweiminütigen Partialdruckanstieg eingelassen wurde. Es stellte sich nach den 2min ein Gesamtdruck in der Vakuumkammer von 20 x 10⁻⁴mbar ein, der Sauerstoffzufluss betrug dann ca. 200sccm/min.

Der Bogenstrom wurde nun auf 150A hochgeregelt und über die Beschichtungsdauer von 60min konstant gehalten. Darnach wurden die Bogenentladung und die Sauerstoffzufuhr abgeschaltet.

Nach dem Abkühlen des Werkstückes wurde die Vakuumkammer geflutet und das beschichtete Werkstück untersucht: Es war eine 5µm dicke, röntgenamorphe Aluminiumoxidschicht entstanden. Neben Aluminium und Sauerstoff in einem Atomverhältnis von 2/3 liessen sich noch 0,5at% Titan in der Schicht nachweisen. Die Bestimmung der Schichthärte erfolgte mit einem Mikrohärteprüfer bei einer Belastung von 0,5N.

Dabei wurde der Knoop-Test eingesetzt, wie er in Anhang A der vorliegenden Anmeldung, "Metallic and related coatings", British Standard Methods of test for, Part 6, Vickers and Knoop microhardness tests, aus BS 5411 : Part 6 : 1981, definiert ist. Die maximal gefundene Mikrohärte wurde bei einer mit 600°C Werkstucktemperatur beschichteten Hartmetallprobe gefunden. Der Härtewert beträgt 1130HK (Härtewert nach Knoop).

### B) Erfindungsgemässe Hartschichtbildung

In einer weiteren Versuchsreihe wurden metallische Aluminium/Chrommischungen verdampft. Angestrebt wurds eine Erhöhung der Schichthärte durch die Bildung der erfindungsgemässen (A1, Cr)₂O₃ Mischkristalle. Für diese Versuche wurde Aluminium und Chrompulver mit einer Korngrösse von 0,5mm innig vermischt und in den oben erwähnten Titan-liner gegeben. Die Prozessparameter für die Verdampfung wurden gegenüber dem oben erwähnten Verdampfen von Aluminium nicht verändert.

Durch Vorversuche wurde die verdampfungscharakteristik von Aluminium/Chrommischungen untersucht. Eine wesentliche, zeitliche Veränderung in den verdampfungsraten von Aluminium und Chrom konnte nicht beobachtet werden. Somit lässt sich durch Aenderung der Einwaage, d.h. des eingewogenen Verhältnisses zwischen Aluminium und Chrom, die Zusamnensetzung der Schicht variieren. Das Mischungsverhältnis von Aluminium und Chrom wurde im Bereich von 90 : 10 bis 50 : 50at% verändert.

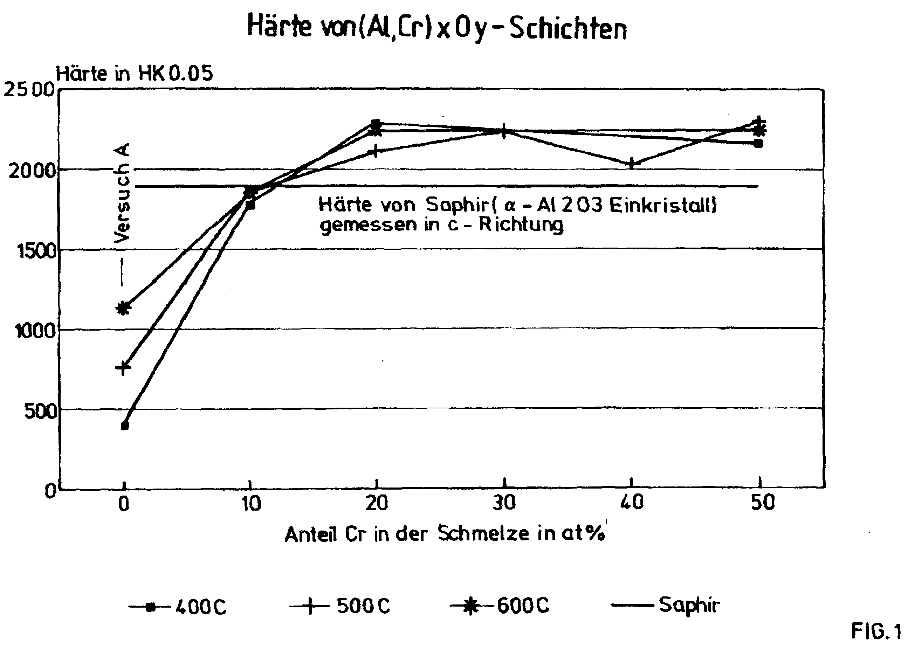

Das Ergebnis der Härteprüfung an den so hergestellten Schichten ist in Fig. 1 wiedergegeben. Man erkennt, dass bereits durch geringe Zugabe von Chrom eine ganz deutliche Härtesteigerung eintritt. Oberhalb eines Chromgehaltes von ca. 20at% wird keine wesentliche Aenderung der Härte gefunden.

Zur Bestimmung der Kristallinität wurden Röntgenbeugungsversuche durchgeführt.

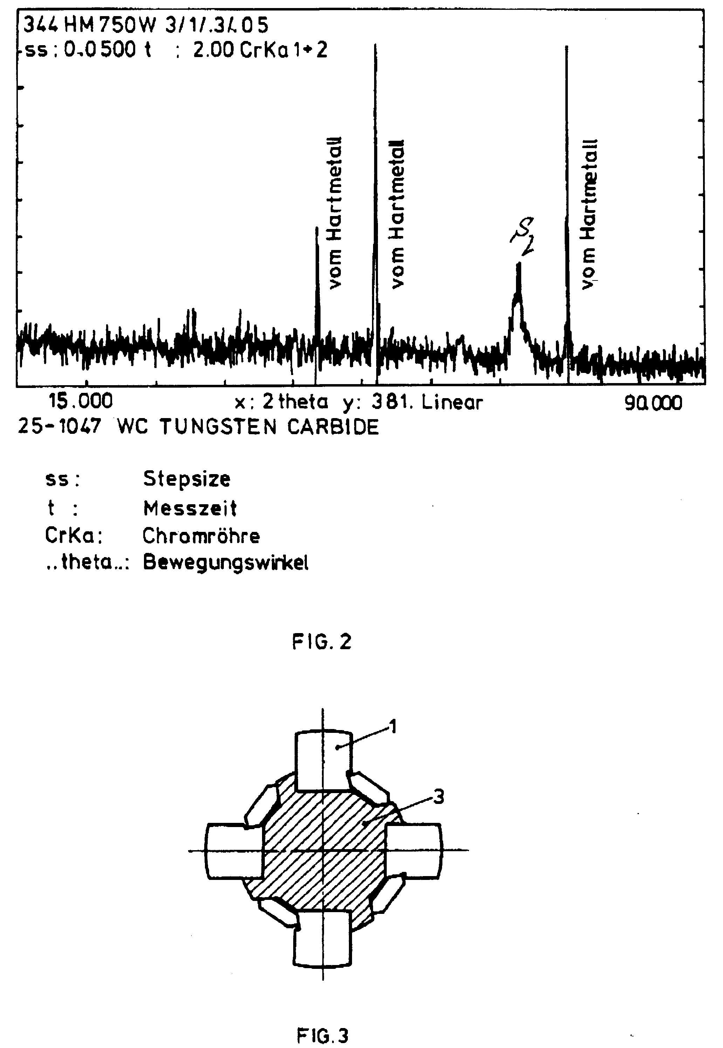

Fig. 2 zeigt das Röntgenspektrum einer bei 500°C mit einem sich aus 90at% Aluminium und 10at% Chrom zusammensetzenden Aufdampfmaterial. Man erkennt die Reflexe vom Hartmetall des Werkstückträgermaterials und den Reflex der Schicht bei S. Der Reflex aus der Schicht wurde als 202-Linie der α-Modifikation von Aluminiumoxid (Korund) identifiziert. Die Linienlage wurde zu 2,009Å bestimmt. Entsprechend dem Chromgehalt verschiebt sich die Linienlage.

So wird z.B. bei einer Schicht, die mit einem Aufdampfmaterial der Zusammensetzung 50at% Aluminium, 50at% Chrom hergestellt wurde, eine Linienlage von 2,037Å bestimmt. Bei kompaktem Korund beträgt der Netzebenenabstand der 202-Linie 1,964Å, und bei Cr₂O₃ 2,048Å: Aufgrund der Druckeigenspannungen der Schichten vergrössert sich der Netzebenenabstand im Vergleich zu einer spannungsfreien Probe um ca. 1 bis 2%. Aus diesem Grunde sind die Linienlagen der Schichten im Vergleich zur linearen Interpolation zwischen den Werten von Al₂O₃ und Cr₂O₃ in Richtung zu Cr₂O₃ hin verschoben.

### B1) Spezifische Anwendungen der erfindungsgemässen Schicht

Mit dem oben beschriebenen Verfahren wurden Wendeschneidplatten aus Hochgeschwindigkeitsstahl HSS beschichtet. Als Schichten wurden einerseits reines Aluminiumoxid und anderseits, gemäss vorliegender Erfindung, (Al, Cr)₂O₃ Schichten der Zusammensetzung 90at% Al, 10at% Cr einerseits und 50at% Al, 50at% Cr anderseits aufgebracht. Es wurden auf den Wendeschneidplatten Schichtdicken von 5µm auf den Spanflächen und von 4µm auf den Freiflächen aufgetragen. Die plattengeometrie war SCFT 120508 FN gemäss Anhang B.

Zerspant wurden Wellen aus unlegiertem Stahl CK 60, entsprechend dem amerikanischen Standard AISI 1064 (Werkstoffnummer 1.1221). Für dieses Längsdrehen wurden folgende Schnittbedingungen gewählt:

| | |
|---|---|
| Schnittgeschwindigkeit: | 100m/min |
| Vorschub: | 0,2mm/U |
| Schnittiefe: | 2mm |
| Kühlung: | mit 3% Emulsion |

Als Standzeitkriterium diente das Erweichen des HSS-Substratmaterials aufgrund erhöhten Verschleisses. Die Standzeiten für die verschiedenen Schichten sind in folgender Tabelle aufgeführt:

| Probe | Schicht | Standzeit in Minuten |
|---|---|---|
| 1 | unbeschichtet | 0.5 |
| 2 | Al₂O₃ | 0.5 |
| 3 | (Al,Cr)₂O₃, 90at% Al, 10at% Cr | 10.5 |
| 4 | (Al,Cr)₂O₃, 50at% Al, 50at% Cr | 10.0 |

Ebenfalls wurde in diesem Test eine mit TiN beschichtete Wendeschneidplatte getestet. Die TiN-Schicht wurde nach dem gleichen Beschichtungsverfahren aufgebracht wie die obgenannten erfindungsgemässen Schichten. Mit der mit TiN beschichteten Platte wurde eine Standzeit von 3,5min erreicht, was wesentlich schlechter ist als die mit den erwähnten erfindungsgemässen Schichten erreichte Standzeit von 10 bzw. 10,5 min.

Das unbefriedigende Standzeitverhalten der in der Tabelle aufgeführten reinen Aluminiumoxidschicht ergibt sich aus deren amorphen Charakter und mithin ihrer geringen Härte. Dadurch sind ein nahezu sofortiger Verschleiss der Schicht durch Abrieb und ein Ausbrechen der Schicht bedingt.

Die mechanisch sehr viels stabileren, härteren kristallinen Schichten mit dem erfindungsgemässen Cr-Anteil von mehr als 5%, vorzugsweise 10 bis 50at%, bieten neben dem für Hartstoffschichten bekanntlich zu fordernden mechanischen Schutz auch eine ausgezeichnete thermische Isolation gegen das Erweichen des HSS-Grundmaterials. Die TiN-Schicht ist auch in dieser Beziehung der erfindungsgemässen Schicht klar unterlegen.

Für einen weiteren Zerspanungsversuch wurden Wendeschneidplatten aus Hartmetall der Anwendungsklasse P30 gemäss Anhang C beschichtet. Die Plattengeometrie war gemäss Anhang B SPUN 120408. Zerspant wurde gemäss Fig. 3 eine mit vier Leisten bestückte Welle 3 gemäss der Beschreibung von J. Fabri, "Anwendungsorientierte Klassifizierung und Prüfung von unbeschichteten und beschichteten Hartmetallen beim Drehen", Diss., T.H. Aachen, 1985, welche der Simulation der Zerspanungsverhältnisse bei unterbrochenem Schnitt dient. Als Leistenmaterial der Leisten 1 wurde der Vergütungsstahl 42 CrMo4 (1.7225) eingesetzt, mit einer Festigkeit von 950N/mm2.

Die Zerspanbedingungen waren

| | |
|---|---|
| - Schnittgeschwindigkeit: | 125m/min |
| - Vorschub: | 0,2mm/U |
| - Schnittiefe: | 2mm. |

Die Vendeschneidglatten waren jeweils bis zum Bruch bzw. bis zu einer Schlagzahl durch die Leisten von 3500 im Eingriff.

Getestet wurden unbeschichtete und mit dem oben beschriebenen erfindungsgemässen Verfahren erfindungsgmäss beschichtete Wendeschneidplatten sowie kommerziell erhältliche Wendeschneidglatten der gleichen Zähigkeitsklasse, die mit einer nach dem CVD-verfahran aufgebrachten reinen Al₂O₃-Schicht versehen waren. Bei diesen Proben war zwischen der 3µm dicken Aluminiumoxidschicht und dem Trägermaterial noch eine Aluminiumoxidschicht und dem Trägermaterial noch eine 2µm dicke TiC-Schicht aufgebracht.

Es zeigte sich, dass nur die unbeschichteten und die erfindungsgemässen Platten das Versuchsende ohne Ausbrechen der Schneide überhaupt erreichten. Bei den mit dem CVD-Verfahren beschichteten Wendeschneidplatten brach im Mittel nach 2500 Leistenschlägen die Schneide aus. Dies ergibt sich aus der Veränderung der Grundmaterialeigenschaften durch die hohen Temperaturen von *ca.* 1000°C und die langen Beschichtungszeiten bei den bekannten CVD-Beschichtungsverfahren.

Nachfolgend sind die nach Versuchsende gemessenen Kolktiefen (KT) und Verschleissmarkenbreiten (VB) der verschiedenen Wendeschneidplatten angegeben.

In Fig. 4 sind schematisch an einer Wendeschneidplatte Kolkerscheinungen (crater) an der Spanfläche (rake-face) dargestellt sowie die Verschleissmarken (wear-land) an der Freifläche (clearance-face). Während die Kolktiefe KT ein Mass für die thermodynamische Stabilität der Schicht ist, ist die Verschleissmarkenbreite VB ein Mass für die abrasive Beanspruchbarkeit.

| Probe | Schicht | KT (µm) | VB (µm) |
|---|---|---|---|
| 1 | unbeschichtet | 95 | 150 |
| 2 | Al₂O₃ | 90 | 150 |
| 3 | (Al,Cr)₂O₃, 90at% Al, 10at% Cr | 10 | 40 |
| 4 | (Al,Cr)₂O₃, 50at% Al, 50at% Cr | 15 | 30 |

Auch bei diesem Versuch zeigt sich das ungenügende Verschleissverhalten der weichen, amorphen Aluminiumoxidschicht mit breiten Verschleissmarken (VB). Das Ergebnis an den erfindungsgemässen (Al, Cr)₂O₃-Schichten spiegelt dabei nicht nur den hoben Verschleisswiderstand dieser Schichten (kleine Verschleissmarkenbreiten) wider, sondern auch die unbedeutende Beeinflussung der Zähigkeitseigenschaften des Grundmaterials bei der Beschichtung. Das unterschiedliche verschleissverhalten der beiden getesteten erfindungsgemässen Schichten (Proben Nr. 3 und 4) ergibt sich aus dem unterschiedlichen Chromgehalt:

Durch tieferen Chromgehalt ergibt sich eine höhere thermodynanische Stabilität (geringere Kolktiefe) bei geringerer abrasiver Beständigkeit (höhere Verschleissmarkenbreite) als bei höherem Chromgehalt (Probe Nr. 4), welche eine geringere thermodynamische Stabilität (grössere Kolktiefe), dafür eine geringere abrasive Verschleissanfälligkeit (geringere Verschleissmarkenbreite) aufzeigt.

Somit ist es möglich, durch selektive Wahl des Chromanteils unterschiedlich beanspruchte Flächen an einem Werkzeug bzw. unterschiedlich beanspruchte Werkzeuge optimal zu beschichten. So wirkt sich eine Beschichtung hoher Härte, beispielsweise gemäss Probe Nr. 4, positiv auf beanspruchte Freiflächen der Wendeschneidplatten aus, während die vornehmlich dem chemischen Verschleiss ausgesetzte Spanfläche am besten durch eine Schicht mit hoher thermodynamischer Stabilität geschützt werden kann, mithin mittels einer erfindungsgemässen Schicht geringeren Chromanteils, beispielsweise gemäss Probe Nr. 3.

In Fig. 5 ist schematisch der Vollständigkeit halber und rein als Beispiel eine Anlage dargestellt, mittels welcher das erfindungsgemässe Verfahren durchgeführt werden kann.

Fig. 5 zeigt eine schematische Darstellung einer beispielsweisen Aufdampfanlage zur Durchführung der erfindungsgemässen Beschichtung.

Die Aufdampfanlage hat eine Vakuumkammer 19 mit einem Evakuierungsanschluss 20 und eine Glühkathodenkammer 21 mit einer Glühkathode 22, die über eine Oeffnung 25 mit der Vakuumkammer 19 verbunden ist. Der die Oeffnung 25 beinhaltende Boden 26 der Glühkathodenkammer 21 ist gegenüber den Wänden der Vakuumkammer 19 elektrisch isoliert. Die Glühkathode 22 wird von einem Stromversorgungsgerät 27 gespeist. Unterhalb der Oeffnung 25 befindet sich über dem Boden 29 der Vakuumkammer 19 ein kühlbarer Tiegel 30, in dem Aluminium und Chrom, vorzugsweise in einem Ti-Liner 30a, liegen. In der Vakuumkammer 19 sind um die Längsachse drehbare, elektrisch leitende Träger 35 vorhanden, an denen die zu beschichtenden Werkstücke 3 an je einer Halterung 36 gehalten werden. Die Träger 35 sind um ihre Achse drehbar auf einem Drehteller 37 angeordnet und durch diesen untereinander elektrisch verbunden. Der Drehteller 37 ist gegenüber dem Boden 29 und den Wänden der Vakuumkammer 19 elektrisch isoliert. Die Halterungen 36 sind mit den Trägern 35 z.B. elektrisch leitend verbunden.

In die Glühkathodenkammer 21 mündet eine Gaszuleitung 39. Die Kammer 21 ist über die Oeffnung 25 mit der Vakuumkammer 19 verbunden.

Der Drehteller 37 kann über eine elektrische Leitung 47 und einen Schalter 46 mit einem einstellbaren Spannungsgenerator 48, dessen anderer Pol geerdet ist, verbunden sein.

Ueber der Glühkathode 22 und dem Tiegel 30 liegt die Spannung eines Stromversorgungsgerätes 32.

Bei 52 ist die Niedervoltentladung auf Tiegel/Liner/Verdampfungsgut dargestellt, bei 53 der Einlass für Argon und Sauerstoff. Die bekannten Anlageteile für das Aetzen der Werkstücke sind nicht dargestellt.

## Patentansprüche

1. Verfahren zum Beschichten eines Werkstückes mit einer Hartschicht mit (Al,Cr)₂O₃, dadurch gekennzeichnet, dass das Werkstück mit (Al,Cr)₂O₃ mittels eines chemischen (CVD) oder physikalischen (PVD) Beschichtungsverfahrens unter Einhalt einer Temperatur unterhalb 900°C beschichtet wird.

2. Verfahren nach Anspruch 1, dadurch gekennzeichnet, dass eine Temperatur von ≤ 500°C eingehalten wird.

3. Verfahren nach einem der Ansprüche 1 oder 2, dadurch gekennzeichnet, dass der Chromanteil in der Schicht zu 10 bis 50at% gewählt wird.

4. Verfahren nach einem der Ansprüche 1 bis 3, dadurch gekennzeichnet, dass in der Schicht ein Ti-Anteil von weniger als 1at% eingebaut wird.

5. Verfahren nach einem der Ansprüche 1 bis 4, dadurch gekennzeichnet, dass das Werkstück an unterschiedlichen Flächenbereichen mit einem unterschiedlichen Chromanteil beschichtet wird.

6. Verfahren nach Anspruch 5, dadurch gekennzeichnet, dass im Einsatz vornehmlich einem chemischen Verschleiss ausgesetzte Werkzeugflächen mit einem höheren Chromanteil beschichtet werden als weniger einem chemischen Verschleiss ausgesetzte Werkzeugflächen.

7. Verfahren nach einem der Ansprüche 1 bis 6, dadurch gekennzeichnet, dass die Beschichtung durch reaktives Zerstäuben oder Verdampfen von Aluminium und Chrom in einer im wesentlichen Sauerstoff enthaltenden Atmosphäre erfolgt.

8. Verfahren nach Anspruch 7, dadurch gekennzeichnet, dass Aluminium und Chrom mittels einer Niedervolt-Bogenentladung verdampft werden.

9. Verfahren nach einem der Ansprüche 1 bis 8, dadurch gekennzeichnet, dass mindestens Aluminium in einem Titan-Liner verdampft wird.

10. Mit einer Hartschicht mit (Al,Cr)₂O₃-Mischkristallen versehener Grundkörper aus Schnellarbeitsstahl oder Hartmetall, dadurch gekennzeichnet, dass die Zähigkeit des Grundkörpers der gleichen Zähigkeitsklasse angehört, wie die Zähigkeit eines gleichen, unbeschichteten Grundkörpers angehört und der Chromanteil in der Hartschicht höher ist als 5at%.

11. Grundkörper nach Anspruch 10, dadurch gekennzeichnet, dass der Chromanteil in der Hartschicht 10 bis 50at% beträgt.

12. Grundkörper nach einem der Ansprüche 10 oder 11, dadurch gekennzeichnet, dass die Schicht weniger als 1at% Ti aufweist.

13. Grundkörper nach einem der Ansprüche 10 bis 12, dadurch gekennzeichnet, dass er ausschliesslich mit der Hartschicht beschichtet ist.

14. Grundkörper nach einem der Ansprüche 10 bis 13, dadurch gekennzeichnet, dass er mit der Hartschicht mit unterschiedlichen Chromanteilen an unterschiedlichen Flächenbereichen versehen ist.

15. Grundkörper nach Anspruch 14, dadurch gekennzeichnet, dass im Einsatz vornehmlich einem chemischen Verschleiss ausgesetzte Flächen einen höheren Chromanteil der Hartschicht aufweisen als weniger einem chemischen Verschleiss ausgesetzte Oberflächenbereiche.

16. Grundkörper nach einem der Ansprüche 10 bis 15, dadurch gekennzeichnet, dass die Mischkristalle vornehmlich in α-Modifikation vorliegen.

17. Verwendung des Verfahrens nach einem der Ansprüche 1 bis 9 für die Beschichtung von Schneidwerkzeugen, insbesondere von Wendeschneidplatten.

18. Verwendung eines Grundkörpers nach einem der Ansprüche 10 bis 16 als Schneidwerkzeug, insbesondere als Wendeschneidplatte.

19. Verwendung des Verfahrens nach einem der Ansprüche 1 bis 9 zum Aufbringen der Hartschicht als thermische Isolationsschicht.

20. Verwendung der Schicht an einem Grundkörper nach einem der Ansprüche 10 bis 16 als thermische Isolationsschicht.

21. Verwendung der nach dem Verfahren nach einem der Ansprüche 1 bis 9 hergestellten Schicht als thermische Isolationsschicht.

## Claims

1. Method for coating a workpiece having a hard coating of (Al,Cr)₂O₃, characterised in that the workpiece is coated with (Al,Cr)₂O₃ by means of a chemical (CVD) or physical (PVD) coating method whilst maintaining a temperature below 900°C.

2. Method according to claim 1, characterised in that a temperature of ≤ 500°C is maintained.

3. Method according to one of claims 1 to 2, characterised in that the chromium content in the coating is chosen to amount to 10 to 50 at %.

4. Method according to one of claims 1 to 3, characterised in that a Ti-share of less than 1 at % is built into the coating.

5. Method according to one of claims 1 to 4, characterised in that the workpiece is coated with a different chromium content on different surface areas.

6. Method according to claim 5, characterised in that, in use, the tool surfaces exposed predominantly to chemical wear are coated with a higher chromium content than the tool surfaces exposed less to chemical wear.

7. Method according to one of claims 1 to 6, characterised in that the coating is applied by means of reactive atomisation or vaporisation of aluminium and chromium in an atmosphere containing mainly oxygen.

8. Method according to claim 7, characterised in that aluminium and chromium are vaporised by means of a low-volt arc discharge.

9. Method according to one of claims 1 to 8, characterised in that at least aluminium is vaporised in a titanium liner.

10. Body provided with a hard coating containing (Al,Cr)₂O₃ mixed crystals and consisting of high-speed steel or hard metal, characterised in that the toughness of the body belongs to the same toughness class as the toughness of a similar uncoated body and in that the chromium content in the hard coating is higher than 5 at %.

11. Body according to claim 10, characterised in that the chromium content in the hard coating is 10 to 50 at %.

12. Body according to one of claims 10 or 11, characterised in that the coating contains less than 1 at % Ti.

13. Body according to one of claims 10 to 12, characterised in that it is coated exclusively with the hard coating.

14. Body according to one of claims 10 to 13, characterised in that it is coated with the hard coating with different chromium contents on different surface areas.

15. Body according to claim 14, characterised in that, in use, surfaces exposed predominantly to chemical wear have a higher chromium content in the hard coating than surface areas exposed to less chemical wear.

16. Body according to one of claims 10 to 15, characterised in that the mixed crystals are present predominantly in α-modification.

17. Use of a method according to one of claims 1 to 9 for coating cutting tools, in particular for indexable inserts.

18. Use of a body according to one of claims 10 to 16 as a cutting tool, in particular as an indexable insert.

19. Use of a method according to one of claims 1 to 9 for applying the hard coating as a thermal insulation layer.

20. Use of the coating on a body according to one of claims 10 to 16 as a thermal insulation layer.

21. Use of the coating manufactured according to the method according to one of claims 1 to 9 as a thermal insulation layer.

## Revendications

1. Procédé pour revêtir une pièce d'une couche dure contenant (Al,Cr)₂O₃, caractérisé en ce qu'on revêt la pièce de (Al,Cr)₂O₃ à l'aide d'un procédé de revêtement chimique (CVD) ou physique (PVD) en respectant une température inférieure à 900°C.

2. Procédé selon la revendication 1, caractérisé en ce qu'on respecte une température ≤ 500°C.

3. Procédé selon l'une des revendications 1 ou 2, caractérisé en ce qu'on choisit une proportion de chrome dans la couche de 10 à 50 %at.

4. Procédé selon l'une des revendications 1 à 3, caractérisé en ce qu'on intègre dans la couche une proportion de Ti inférieure à 1 %at.

5. Procédé selon l'une des revendications 1 à 4, caractérisé en ce qu'on revêt la pièce avec des proportions de chrome différentes sur des zones superficielles différentes.

6. Procédé selon la revendication 5, caractérisé en ce qu'on revêt les surfaces d'outils exposées surtout à une usure chimique, lors de leur utilisation, avec une proportion de chrome plus grande que les surfaces d'outils moins exposées à une usure chimique.

7. Procédé selon l'une des revendications 1 à 6, caractérisé en ce que le revêtement se fait par pulvérisation réactive ou vaporisation d'aluminium et de chrome dans une atmosphère contenant essentiellement de l'oxygène.

8. Procédé selon la revendication 7, caractérisé en ce qu'on vaporise l'aluminium et le chrome à l'aide d'une décharge en arc basse tension.

9. Procédé selon l'une des revendications 1 à 8, caractérisé en ce qu'on vaporise au moins l'aluminium dans une garniture en titane.

10. Corps de base en acier rapide ou en métal dur, pourvu d'une couche dure contenant des cristaux mixtes de (Al,Cr)₂O₃, caractérisé en ce que la dureté du corps de base entre dans la même catégorie de dureté que celle d'un corps de base identique non revêtu, et la proportion de chrome dans la couche dure est supérieure à 5 %at.

11. Corps de base selon la revendication 10, caractérisé en ce que la proportion de chrome dans la couche dure est de 10 à 50 %at.

12. Corps de base selon l'une des revendications 10 ou 11, caractérisé en ce que la couche comporte moins de 1 %at. de Ti.

13. Corps de base selon l'une des revendications 10 à 12, caractérisé en ce qu'il est revêtu exclusivement de la couche dure.

14. Corps de base selon l'une des revendications 10 à 13, caractérisé en ce qu'il est pourvu de la couche dure avec des proportions de chrome différentes sur des zones superficielles différentes.

15. Corps de base selon la revendication 14, caractérisé en ce que les surfaces exposées surtout à une usure chimique, lors de leur utilisation, présentent une proportion de chrome plus élevée, dans la couche dure, que les zones superficielles qui sont moins exposées à une usure chimique.

16. Corps de base selon l'une des revendications 10 à 15, caractérisé en ce qu'on trouve les cristaux mixtes surtout sous la forme modifiée a.

17. Utilisation du procédé selon l'une des revendications 1 à 9 pour le revêtement d'outils de coupe, en particulier de plaquettes réversibles.

18. Utilisation d'un corps de base selon l'une des revendications 10 à 16 comme outil de coupe, en particulier comme plaquette réversible.

19. Utilisation du procédé selon l'une des revendications 1 à 9 pour appliquer la couche dure sous la forme d'une couche d'isolation thermique.

20. Utilisation de la couche sur un corps de base selon l'une des revendications 10 à 16 comme couche d'isolation thermique.

21. Utilisation de la couche fabriquée à l'aide du procédé selon l'une des revendications 1 à 9 comme couche d'isolation thermique.
